(19) **Europäisches Patentamt**

**European Patent Office**

**Office européen des brevets**

(11) **EP 1 094 512 A1**

(12) **EUROPEAN PATENT APPLICATION**
published in accordance with Art. 158(3) EPC

(43) Date of publication:
25.04.2001 Bulletin 2001/17

(51) Int. Cl.⁷: **H01L 21/56**

(21) Application number: **99961462.1**

(86) International application number:
**PCT/JP99/07387**

(22) Date of filing: **28.12.1999**

(87) International publication number:
**WO 00/62338 (19.10.2000 Gazette 2000/42)**

(84) Designated Contracting States:
**AT BE CH CY DE DK ES FI FR GB GR IE IT LI LU MC NL PT SE**

(30) Priority: **12.04.1999 JP 10355999**

(71) Applicant:
**Nitto Denko Corporation
Ibaraki-shi, Osaka 567-0041 (JP)**

(72) Inventors:
• **FURUTA, Yoshihisa,
Nitto Denko Corporation
Ibaraki-shi, Osaka 567-0041 (JP)**

• **WATANABE, Yoshinori,
Nitto Denko Corporation
Ibaraki-shi, Osaka 567-0041 (JP)**

(74) Representative:
**Grünecker, Kinkeldey,
Stockmair & Schwanhäusser
Anwaltssozietät
Maximilianstrasse 58
80538 München (DE)**

(54) **SEMICONDUCTOR CHIP RESIN-SEALING METHOD AND ADHESIVE TAPE FOR PASTING LEAD FRAMES OR THE LIKE**

(57) A pressure-sensitive adhesive tape (2) is adhered to a leadframe (1). A semiconductor chip (3) is bonded to the leadframe (A) having the pressure-sensitive adhesive tape and encapsulated with a resin in a mold (4). The pressure-sensitive adhesive tape (2) is stripped after the encapsulating. The resin encapsulating efficiency is improved, and breakage of bonding parts is prevented with certainty.

FIG.3

**Description**

Technical Field

This invention relates to a method of encapsulating a semiconductor chip with a resin and a pressure-sensitive adhesive tape used therein for adhesion to a leadframe and the like.

Background Art

In the manufacture of packaged semiconductor devices such as QFP, a semiconductor chip is bonded on a leadframe, put in a cavity of a mold, and encapsulated with a resin by transfer molding.

It is necessary to secure a fairly wide contact area between the mold and the leadframe in order to prevent resin from leaking from the contact interface. The ratio of the contact area to the cavity space should be considerably high. It follows that the number of chips encapsulated in a single shot with a mold of a size is reduced, which is disadvantageous for working efficiency.

There is also a fear that the chip moves with the resin flowing into the mold to break the bonding parts. The mold structure is therefore unavoidably complicated to eliminate this.

It is an object of the present invention to provide a method of encapsulating a semiconductor chip with a resin which achieves improved efficiency of resin encapsulating while preventing breakage of bonding parts without fail.

Disclosure of the Invention:

The resin encapsulating method for a semiconductor chip according to the present invention comprises adhering a pressure-sensitive adhesive tape to a leadframe or a film carrier tape, bonding a semiconductor chip to the leadframe or carrier tape having the pressure-sensitive adhesive tape, encapsulating the semiconductor chip with a resin in a mold, and stripping the pressure-sensitive adhesive tape, wherein the pressure-sensitive adhesive tape has a thermal shrinkage of 3% or less on resin encapsulating. The expression "a thermal shrinkage of 3% or less on resin encapsulating" as used herein is intended to mean that the thermal shrinkage of the tape in at least one of the width and the lengthwise directions is 3% or less at a encapsulating temperature.

Brief Description of the Drawings

Figs. 1A to 1E represent an example of the method of encapsulating a semiconductor chip with a resin according to the present invention.
Fig. 2 shows the leadframe in Figs. 1A to 1E.
Fig. 3 is a cross section of Fig. 1C taken along line III-III.

Best Mode for Carrying out the Invention

The practice of carrying out the invention will be described hereunder by referring to the drawings.

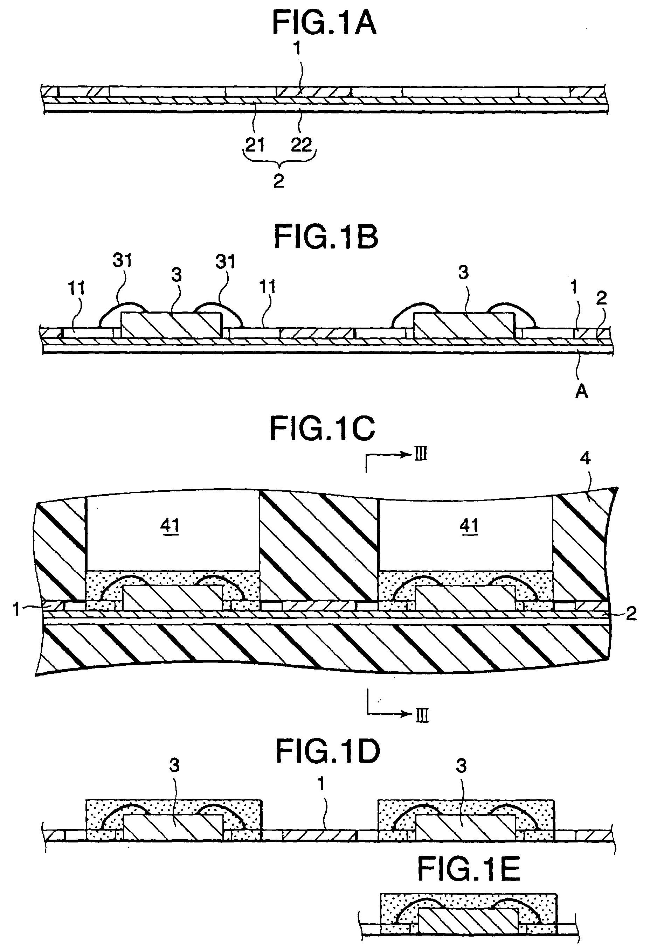

Figs. 1A to 1E is a drawing showing an example of the method for encapsulating a semiconductor chip with a resin according to the present invention.

Fig. 1A shows a leadframe A with an pressure-sensitive adhesive tape adhered thereto, wherein numeral 1 is a leadframe having a group of units each having a large number of stitches 11 arranged around the device hole. Numeral 2 is an pressure-sensitive adhesive tape affixed to the leadframe 1, whose thermal shrinkage on resin encapsulating is controlled to 3% or less, preferably 2% or less, still preferably 1% or less. Numerals 21 and 22 are a pressure-sensitive adhesive layer and a substrate, respectively.

In producing resin-encapsulated semiconductor chips according to the present invention, semiconductor chips 3 are placed and fixed in the device holes, one by one, of the leadframe A with the pressure-sensitive adhesive tape adhered thereto, and the chip 3 and the stitches 11 of the leadframe 1 are bonded with a bonding wire 31 as shown in Fig. 1B. In the step of resin encapsulating, the semiconductor chip 3 is placed in each cavity 41 of a mold 4 and encapsulated with a resin by transfer molding as shown in Fig. 1C. Then as shown in Fig. 1D, the pressure-sensitive adhesive tape is stripped off the leadframe 1, and the leadframe is cut and trimmed to obtain a resin-encapsulated semiconductor chip shown in Fig. 1E.

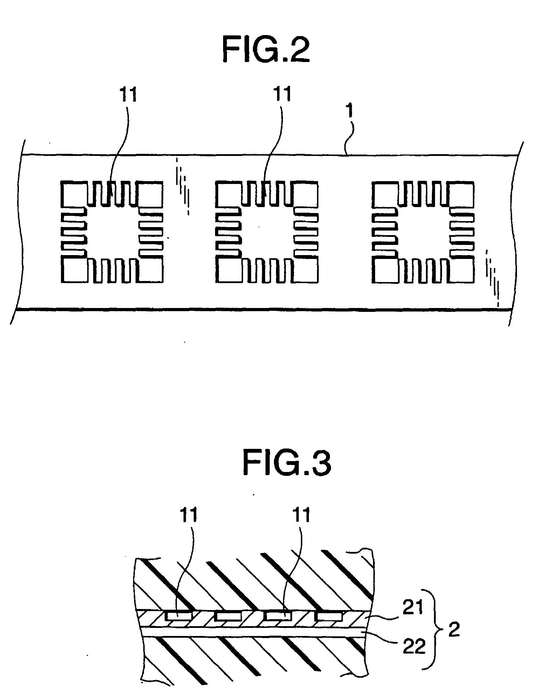

Fig. 3 shows the contact interface between the mold and the leadframe. The stitches 11 of the leadframe bite into the pressure-sensitive adhesive layer 21 of the pressure-sensitive adhesive tape 2 so that the pressure-sensitive adhesive layer 21 and the stitches 11 are co-planar. The pressure-sensitive adhesive layer 21 among the stitches adheres to the mold 4 and acts as a sealant to exhibit high encapsulating properties. Therefore, the encapsulating effect can be exerted by increasing the thickness of the pressure-sensitive adhesive layer 21. Where the encapsulating resin fills deep into the gaps between stitches 11, a sufficient encapsulating effect can be exhibited by increasing the mold pressure or adhesive strength. Such manipulations can be selected according to the end use.

The pressure-sensitive adhesive tape shrinks during resin encapsulating because it is also heated by the heat of the mold. A fear is entertained that the thermal shrinkage of the pressure-sensitive adhesive tape may cause a shear stress in the interface between the leadframe with the adhesive tape and the mold, and a high shear stress would deteriorate the encapsulating properties due to the shearing strain. In the present invention, since the pressure-sensitive adhesive tape used has a thermal shrinkage of not more than 3%, preferably 2% or less, still preferably 1% or less, on resin encapsulating, the above-described high encapsulating performance can be secured during the resin encapsulating.

Accordingly, even though the contact interface between the mold and the leadframe is made smaller, sufficient encapsulating can be achieved. With the smaller contact interface, the number of cavities per mold can be increased so that the number of chips encapsulated per shot can be increased. Since the chips are fixed onto the pressure-sensitive adhesive layer, the chips can be stably maintained in their fixed state against the resin flow thereby preventing breakage of the bonding parts.

The pressure-sensitive adhesive strength of the pressure-sensitive adhesive tape is desirably as high as possible for encapsulating the contact between the mold and the leadframe but is desirably as low as possible for strippability from the leadframe after resin encapsulating. It is preferred to use a pressure-sensitive adhesive tape having a pressure-sensitive adhesive strength to the leadframe of 400 gf/20 mm or less, preferably 300 gf/20 mm or less and 5 gf/20 or more, at 23°C. If the pressure-sensitive adhesive strength is less than 5 gf/20 mm, the pressure-sensitive adhesive tape tends to separate during use.

The heating conditions for resin encapsulating is usually about 180°C. It is a matter of course that the pressure-sensitive adhesive tape is required to have heat resistance to the heating temperature.

The substrate of the pressure-sensitive adhesive tape can be of heat-resistant materials satisfying the above-described various conditions, for example, heat-resistant plastic films of polyimide, polyphenylene sulfide, etc., glass cloth, and the like. Where the heating condition of the resin encapsulating is 150°C or lower, a polyethylene terephthalate film may be used.

The pressure-sensitive adhesives of the pressure-sensitive adhesive tape include not only acrylic pressure-sensititive adhesives and silicone pressure-sensitive adhesives but also epoxy adhesives as far as the above-described various conditions are met. It is preferred to use silicone pressure-sensitive adhesives having excellent heat resistance. In order to satisfy the above-specified requirement in terms of peel strength, heat-resistant fillers (such as glass beads, various inorganic fillers, arid heat-resistant organic fillers) can be added to the pressure-sensitive adhesive if desired. It is also possible to use a foaming adhesive which foams by the heat of resin encapsulating to reduce the peel strength to 400 gf/20 mm-tape width or less.

The thickness of the substrate is from 5 to 250 μm, preferably 5 to 100 μm. If the thickness is smaller than 5 μm, the adhesive tape tends to be fractured, torn, or blistered, causing reduction of workability. If it exceeds 250 μm, the heat conduction efficiency from the mold to the resin is reduced.

The thickness of the pressure-sensitive adhesive layer is from 2 to 100 μm, preferably 5 to 75 μm. If the thickness is less than 2 μm, there is a difficulty in coating, and an adhesive failure or blisters are liable to be caused. If it exceeds 100 μm, there is a difficulty in coating, and the adhesive tends to be pressed out from the edges, which attracts foreign matter and gives off increased gas on heating.

The pressure-sensitive adhesive layer can be crosslinked appropriately in order that it can be stripped by interfacial separation without leaving any adhesive due to cohesive failure or in order to control the adhesive strength.

In order to prevent delamination between the substrate and the pressure-sensitive adhesive layer, the substrate can be subjected, if desired, to primer coating or surface roughening, for example, sputter etching.

In order to increase the heating efficiency in the resin encapsulating, heat conductive particles, such as boron nitride, can be added to the pressure-sensitive adhesive layer.

Frictional electricity is generated during the production of the semiconductor devices. In case there is a fear of the chip's destruction due to an electric shock, the substrate can be of an electrically conductive material, and the pressure-sensitive adhesive layer can be made electrically conductive by addition of conductive particles, such as carbonickel or carbon black.

The present invention is applicable to a TAB system. In this case, the pressure-sensitive adhesive tape is stuck to the back side of a film carrier tape (e.g., a polyimide film having copper foil finger leads), and semiconductor chips are disposed and fixed one by one in the device holes of the carrier tape with the pressure-sensitive adhesive tape. Each of the chips and the finger leads of the film carrier tape are connected by Au-Sn eutectic bonding. In the step of resin encapsulating, the semiconductor chips are put in the respective cavities of a mold and encapsulated with a resin by transfer injection molding. The film carrier tape is then trimmed to obtain resin-encapsulated semiconductor chips.

The present invention will now be illustrated in greater detail by way of Examples and Comparative Examples, but the present invention is not deemed to be limited thereto.

Comparative Example 1

Chips bonded to a leadframe (Cu-based; number of stitches: 100) having no pressure-sensitive adhesive tape were put in a mold and encapsulated with a resin at 200°C and 20 kg/cm$^2$. As a result, resin leaks occurred.

Example 1

A platinum catalyst (0.5 part by weight) was uniformly mixed into 100 parts by weight of a silicone pressure-sensitive adhesive. The mixture was applied to a 25 μm thick polyimide film and dried by heating at 130°C for 5 minutes to prepare a pressure-sensitive adhesive tape having a pressure-sensitive adhesive layer of 10 μm in thickness.

The pressure-sensitive adhesive tape had a thermal shrinkage of 0.5% or less at 200°C and, when adhered to a leadframe, showed an initial pressure-sensitive adhesive strength of 60 gf/20 mm at 23°C, a pressure-sensitive adhesive strength of 180 gf/20 mm after 200°C x 1 hour, and a pressure-sensitive adhesive strength of 200 gf/20 mm after 200°C x 5 hours. The thermal shrinkage was determined by allowing a 300 mm long and 19 mm wide tape sample marked with two gauges at a distance of 200 mm to stand at 200°C for 2 hours and, after allowing the sample to cool to 23°C, measuring the distance between the two gauge marks. The thermal shrinkage was obtained as [(distance between two gauge marks before shrinkage - distance between two gauge marks after shrinkage) /distance between two gauge marks before shrinkage] x 100 (%).

The pressure-sensitive adhesive tape was stuck to the same leadframe as used in Comparative Example 1, and resin encapsulating was carried out in the same manner as in Comparative Example 1. The pressure-sensitive adhesive tape was then peeled. No resin leak nor deformation of the leadframe was observed.

Example 2

Resin encapsulating was carried out in the same manner as in Example 1, except for using an available silicone pressure-sensitive adhesive tape (pressure-sensitive adhesive layer thickness: 30 μm; substrate thickness: 25 μm) which has a thermal shrinkage of 0.5% or less at 200°C and, when adhered to a leadframe, shows an initial pressure-sensitive adhesive strength of 500 gf/20 mm at 23°C, a pressure-sensitive adhesive strength of 550 gf/20 mm after 200°C x 1 hour, and a pressure-sensitive adhesive strength of 550 gf/20 mm after 200°C x 5 hours. Because of the higher pressure-sensitive adhesive strength of the pressure-sensitive adhesive tape than that of Example 1, the leadframe was slightly deformed on peeling the adhesive tape, but no resin leak occurred.

This Example lends confirmation to the advantage of using a pressure-sensitive adhesive tape having an adhesive strength of 400 gf/20 mm or less after resin encapsulating.

Example 3

Resin encapsulating was carried out in the same manner as in Example 1, except for using a silicone pressure-sensitive adhesive tape (pressure-sensitive adhesive layer thickness: 10 μm; substrate thickness: 25 μm) which had a thermal shrinkage of 2% or less at 200°C and, when adhered to a leadframe, shows an initial pressure-sensitive adhesive strength of 220 gf/20 mm at 23°C, a pressure-sensitive adhesive strength of 300 gf/20 mm after 200°C x 1 hour, and a pressure-sensitive adhesive strength of 300 gf/20 mm after 200°C x 5 hours. The same results as in Example 1 were obtained.

Comparative Example 2

Resin encapsulating was carried out in the same manner as in Example 1, except for using an available silicone pressure-sensitive adhesive tape (pressure-sensitive adhesive layer thickness: 30 μm; substrate thickness: 25 μm) which has a thermal shrinkage of 7.5% at 200°C and, when adhered to a leadframe, shows an initial pressure-sensitive adhesive strength of 700 gf/20 mm at 23°C, a pressure-sensitive adhesive strength of 750 gf/20 mm after 200°C x 1 hour, and a pressure-sensitive adhesive strength of 750 gf/20 mm after 200°C x 5 hours. As a result, resin leaks occurred, and the leadframe underwent deformation during resin encapsulating. The above results prove the significance of using a pressure-sensitive adhesive tape having a thermal shrinkage of 3% or less on resin encapsulating.

Industrial Applicability

When semiconductor chips are each bonded to a leadframe or a tape carrier and encapsulated with a resin in a mold, the present invention makes it feasible to sufficiently reduce the area of the contact interface between the leadframe, etc. and the mold. As a result, the number of cavities per mold can be increased so that the number of chips encapsulated in a single shot can be increased, leading to improved efficiency in resin encapsulating.

Further, the present invention satisfactorily prevents breakage of bonding parts during resin encapsulating, providing an excellent yield in resin encapsulating.

Furthermore, the present invention prevents foreign matter's entering the stitches of a leadframe, development of scratches, dusting due to resin leaks, and so forth, leading to improved resin encapsulating quality.

**Claims**

1.  A resin encapsulating method for a semiconductor chip comprising adhering a pressure-sensitive adhesive tape to a leadframe, bonding a semiconductor chip to the leadframe having the pressure-sensitive adhesive tape adhered thereto, encapsulating the semiconductor chip with a resin in a mold, and stripping the pressure-sensitive adhesive tape, wherein the pressure-sensitive adhesive tape has a thermal shrinkage of 3% or less on resin encapsulating.

2.  A resin encapsulating method for a semiconductor chip according to claim 1, wherein a tape carrier film is used in place of the leadframe.

3.  A pressure-sensitive adhesive tape to be adhered to a leadframe and the like, which is used in the resin encapsulating method for a semiconductor chip according to claim 1 or 2 and has a thermal shrinkage of 3% or less on resin encapsulating.

# FIG.1A

# FIG.1B

# FIG.1C

# FIG.1D

# FIG.1E

# FIG.2

# FIG.3

# INTERNATIONAL SEARCH REPORT

| International application No. |
|---|
| PCT/JP99/07387 |

| A. CLASSIFICATION OF SUBJECT MATTER |
|---|
| Int.Cl⁷   H01L21/56 |

According to International Patent Classification (IPC) or to both national classification and IPC

| B.   FIELDS SEARCHED |
|---|
| Minimum documentation searched (classification system followed by classification symbols)<br>    Int.Cl⁷   H01L21/56 |

Documentation searched other than minimum documentation to the extent that such documents are included in the fields searched

|  |  |  |  |
|---|---|---|---|
| Jitsuyo Shinan Koho | 1926-1996 | Toroku Jitsuyo Shinan Koho | 1994-2000 |
| Kokai Jitsuyo Shinan Koho | 1971-2000 | Jitsuyo Shinan Toroku Koho | 1996-2000 |

Electronic data base consulted during the international search (name of data base and, where practicable, search terms used)

| C.   DOCUMENTS CONSIDERED TO BE RELEVANT | | |
|---|---|---|
| Category* | Citation of document, with indication, where appropriate, of the relevant passages | Relevant to claim No. |
| Y | JP, 02-10748, A (Toshiba Corporation),<br>16 January, 1990 (16.01.90),<br>Full text    (Family: none) | 1-3 |
| Y | JP, 11-74412, A (Hitachi, Ltd.),<br>16 March, 1999 (16.03.99),<br>Full text    (Family: none) | 1-3 |
| Y | JP, 10-189626, A (Nippon Retsuku K.K.),<br>21 July, 1998 (21.07.98),<br>Full text    (Family: none) | 1-3 |

| ☐ Further documents are listed in the continuation of Box C. | ☐ See patent family annex. |
|---|---|

| * | Special categories of cited documents: |
|---|---|
| "A" | document defining the general state of the art which is not considered to be of particular relevance |
| "E" | earlier document but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>    28 March, 2000 (28.03.00) | Date of mailing of the international search report<br>    11 April, 2000 (11.04.00) |
|---|---|
| Name and mailing address of the ISA/<br>    Japanese Patent Office | Authorized officer |
| Facsimile No. | Telephone No. |

Form PCT/ISA/210 (second sheet) (July 1992)

8